## Europäisches Patentamt
## European Patent Office
## Office européen des brevets

(19)

(11) Numéro de publication : **0 217 846 B1**

(12)

# FASCICULE DE BREVET EUROPEEN

(45) Date de publication du fascicule du brevet :
24.07.91 Bulletin 91/30

(51) Int. Cl.⁵ : **G11C 5/00, G11C 16/00,**
   **G11C 29/00**

(21) Numéro de dépôt : 86901920.8

(22) Date de dépôt : 04.04.86

(86) Numéro de dépôt international :
PCT/FR86/00115

(87) Numéro de publication internationale :
WO 86/06205 23.10.86 Gazette 86/23

(54) **MEMOIRE MORTE PROGRAMMABLE ELECTRIQUEMENT.**

(30) Priorité : 12.04.85 FR 8505563

(43) Date de publication de la demande :
15.04.87 Bulletin 87/16

(45) Mention de la délivrance du brevet :
24.07.91 Bulletin 91/30

(84) Etats contractants désignés :
DE FR GB IT NL

(56) Documents cités :
US-A- 4 253 059
US-A- 4 460 982
Patents Abstracts of Japan, volume 1, no. 159
16 décembre 1977, page 859E77 & JP, A,
52101934 (TOKYO SHIBAURA DENKI K.K.) 26
août 1977

(56) Documents cités :
Patents Abstracts of Japan, volume 5, no. 107
(P-70)(779), 11 juillet 1981 & JP, A, 5651090
(TOKYO SHIBAURA DENKI K.K.) 8 mai 1981
IEEE Transactions on Electron Devices ,
volume ED-27, no. 7, juillet 1980, IEEE New
York, (US) B. Gerber et al.: "Low-voltage single supply CMOS electrically erasable readonly memory", pages 1211-1216

(73) Titulaire : SGS THOMSON
MICROELECTRONICS SA
7, Avenue Galliéni
F-94250 Gentilly (FR)

(72) Inventeur : SILVESTRE DE FERRON, Gérard
Villa des Pins Ch. Charbonnières
F-13850 Greasque (FR)

(74) Mandataire : Ballot, Paul Denis Jacques et al
Cabinet Ballot-Schmit 7, rue le Sueur
F-75116 Paris (FR)

## Description

La présente invention a pour objet une mémoire morte programmable électriquement par exemple EPROM ou EEPROM comme décrite dans le préambule de la revendication 1 et comme connue par exemple du document IEEE Transactions on Electron Devices, vol-ED-27, no.7, juillet 1980, p.1211 - 1216.

Ces mémoires présentent l'avantage que leur programmation peut être faite par l'utilisateur. Par ailleurs, dans certains cas, elles peuvent même être effacées puis réécrites un certain nombre de fois si le besoin s'en fait sentir. L'élément de stockage d'information y est un transistor à grille flottante. Ce transistor peut avoir deux états. Dans un premier état, aucune charge n'est piégée sur la grille flottante. Un canal de conduction peut être installé entre source et drain de ce transistor. Celui-ci peut donc conduire ; il se comporte comme un interrupteur fermé. Dans un deuxième état, des électrons ont été piégés sur la grille flottante. Ils empêchent la création d'un canal de conduction dans le substrat entre source et drain. Le transistor est bloqué et se comporte comme un interrupteur ouvert. L'intérêt de ce type d'élément de stockage réside dans la non volatilité des informations enregistrées. Les charges électriques piégées dans la grille flottante ne fuient que lentement. La perte de charge dans la grille flottante détermine le temps de rétention d'un point mémoire. Au bout de ce temps, l'information stockée n'est plus lisible. Cette durée de rétention est généralement de l'ordre de 5 à 10 ans, elle dépend de l'amplitude et de la durée de la tension appliquée lors de la programmation. Des valeurs typiques de programmation sont 21 volts et 50 millisecondes.

L'état passant ou bloqué du transistor se mesure en envoyant une impulsion de sélection sur sa grille de commande. Dans l'état passant, aucune charge n'est piégée sur la grille flottante, et la tension de sélection appliquée met le transistor en saturation. Sur le plan pratique, le transistor est relié par une première électrode principale à une ligne de bit polarisée en tension par un générateur ; par son autre électrode principale il est relié à la masse. La ligne de bit est également reliée à un senseur de courant : ce senseur mesure le courant débité dans la ligne par le générateur. Lorsque le transistor devient passant, il court-circuite le générateur et le senseur détecte une chute de courant. Cette chute de courant est exploitée ultérieurement comme représentative de l'information correspondant à l'état de programmation du transistor solicité. Dans un deuxième cas, lorsque le point mémoire est programmé, des charges sont piégées sur la grille flottante du transistor. La tension de sélection appliquée sur la grille de commande est de sens opposé à la barrière de potentiel créée, dans le canal de conduction, par les charges stockées dans la grille flottante. Mais elle est alors insuffisante pour modifier la conduction de ce canal : le transistor reste bloqué. En conséquence le senseur en bout de la ligne de bit ne perçoit pas de variation de courant. Il détecte ainsi, au moment de la sélection du point mémoire considéré, un état inverse du premier cas.

Un des domaines les plus accueillants de la technologie des mémoires mortes programmables électriquement est celui des cartes à mémoire. Une carte à mémoire est une carte, par exemple au format d'une carte de crédit du système bancaire : un circuit intégré électronique est enchâssé dans cette carte, et des bornes de connexion électrique sont accessibles en surface pour que des opérations puissent être exécutées avec la carte dans un terminal. Le problème fondamental des cartes à mémoire est celui de la fraude. On cherche à empêcher les détenteurs de falsifier les informations contenues dans les mémoires des cartes. Un premier risque à éviter est celui de l'introduction, dans de mauvaises conditions, d'informations critiques dans la mémoire. Aussi dans une première phase ces informations sont introduites par l'intermédiaire de séries d'impulsions électriques appliquées aux bornes de cette mémoire. Pour s'assurer que les informations ont été correctement introduites, on vérifie alors le contenu de la mémoire en appliquant à des bornes d'accès des impulsions électriques de vérification.

Mais on ne sait pas vérifier le pouvoir de rétention effectif des informations stockées dans les points mémoire. On soupçonne en fait les fraudeurs de trafiquer les bornes d'accès, par exemple en les recouvrant d'une couche minuscule de graphite qui constitue une résistance. De cette manière la programmation des informations dans la mémoire ne se fait pas à un niveau suffisant pour que la rétention des informations corresponde à une durée souhaitée. On pourrait penser que cette fraude peut être détectée en envoyant, lors de la vérification, des impulsions électriques adéquates sur les bornes d'accès de vérification. Mais on soupçonne également les fraudeurs d'avoir l'intention de trafiquer également les bornes d'accès de vérification (vraisemblablement de la même manière). Autrement dit on pense qu'un fraudeur habile pourrait modifier les conditions de programmation de la mémoire, même si cette programmation est effectuée par l'organisme émetteur des cartes à mémoire en question. La vérification s'avérerait alors tout aussi illusoire puisque pratiquée dans les mêmes conditions.

La présente invention propose une solution efficace à ce problème : les potentiels des impulsions utilisées en vérification ne sont pas dans l'invention des potentiels appliqués extérieurement à la mémoire, mais plutôt des potentiels fabriqués intérieurement par celle-ci. La fixation du niveau de potentiel utile à la programmation détermine de manière irrémédiable la durée de rétention des informations qu'elle contient. La fixation intrinsèque du niveau de potentiel utilisé par les impulsions de vérification permet de vérifier la réalité des informations stockées dans la mémoire.

Ceci signifie encore que, dans l'invention, si on programme et si on vérifie les informations programmées, on le fait bien ou on ne le fait pas du tout. Dans l'état de la technique critiqué, des informations pouvaient être programmées, puis mal vérifiées, pour laisser croire, pendant quelques temps, à une intégrité de façade des informations stockées. Passé un certain délai, les informations devenaient illisibles : en fait les uns devenaient des zéros. Ceci modifiait singulièrement les informations stockées, surtout si celles-ci étaient réputées représenter un solde de compte bancaire.

L'objet de l'invention est défini dans la revendication 1.

L'invention sera mieux comprise à la lecture de la description qui suit et à l'examen des figures qui l'accompagnent. Sur ces figures les mêmes repères désignent les mêmes éléments. Elles ne sont données qu'à titre indicatif et nullement limitatif de l'invention. Elles représentent :

– figures 1a et 1b un diagramme de fonctionnement électrique d'un point mémoire avec transistor à grille flottante ;

– figure 2, une mémoire conforme à l'invention.

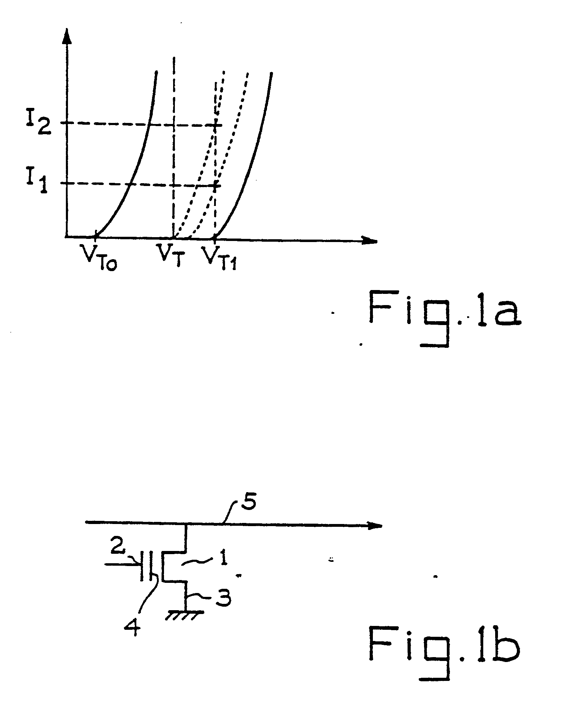

La figure 1a représente le diagramme de la caractéristique de fonctionnement d'un transistor à grille flottante. Celui-ci est vu par ailleurs sur la figure 1b. En ordonnée du diagramme apparaît le courant traversant le transistor 1. En abscisse on porte la tension appliquée entre la grille de lecture 2 et une borne principale 3 du transistor. La figure 1a comporte deux courbes. Une première courbe indique qu'un courant commence à traverser à partir d'une tension $V_{To}$, et une deuxième courbe indique qu'un courant commence à traverser à partir d'une tension $V_{T1}$. La première correspond à un transistor à grille flottante non programmé (en fait programmé à un) : aucune charge n'est piègée sur la grille flottante 4. La barrière de potentiel de ce transistor vaut $V_{TO}$. Lorsque l'on applique à ce transistor, sur sa grille 2, une impulsion de tension (marquée en tirets) dont la valeur vaut $V_T$, ce transistor devient passant : il court-circuite une ligne de bit 5 à la masse. Par contre la courbe de droite correspond à un transistor comportant des charges piègées sur sa grille flottante, de telle manière que sa barrière de potentiel soit translatée de $V_{TO}$ à $V_{T1}$. Il est programmé à zéro. Reçevant également une impulsion de sélection de valeur $V_T$, ce transistor continue à être bloqué : aucun courant n'est court-circuité de la ligne de bit 5 vers la masse. En position intermédiaire entre ces deux courbes, sont représentées en pointillées deux autres courbes correspondant à des transistors programmés à zéro mais dont la grille flottante comporte de moins en moins de charges piègées. Les charges piègées sont cependant encore suffisamment nombreuses pour que la barrière de potentiel de ces transistors soit supérieure à la tension de sélection $V_T$ qui sert à la lecture normale des cellules. Si l'on soumet ces transistors à des tensions de sélection supérieures, par exemple égales à $V_{T1}$, ils laissent passer vers la masse des courants respectivement I1 et I2 montrant, par l'importance de ces courants, leur défaut de capacité de rétention. Ils sont correctement programmés (pour une tension $V_T$) mais leur capacité de rétention est mauvaise. La fraude soupçonnée consiste justement à modifier les tensions de programmation pour que le nombre des charges piègées soit tout juste insuffisant. Elle consiste également à modifier la tension de vérification $V_{T1}$ (en la réduisant notablement par exemple) pour qu'elle ne laisse pas apparaître de courants tels que I1 ou I2 qui renseignent sur le défaut de capacité de rétention. Passé un certain temps, et une fois que les couches surrajoutées de graphite auraient été enlevées, on lirait tout naturellement un un là où auparavant on aurait prétendu inscrire un zéro.

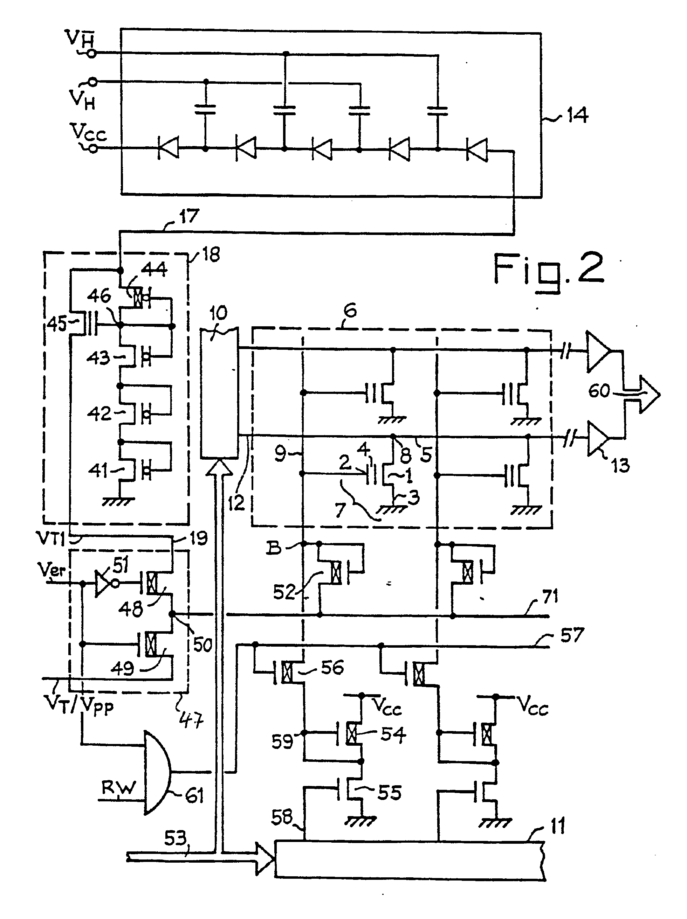

Pour remédier à ces tentatives de fraude, dans l'invention on a tout simplement décidé de produire à l'intérieur de la mémoire les tensions de vérification $V_{Tl}$. On peut également décider d'y produire les tensions de lecture $V_T$ et de programmation $V_{PP}$. La figure 2 montre une mémoire 6 programmable électriquement. Elle est du type à point mémoire 7 avec transistor 1 à grille flottante 4. Les transistors 1 possèdent deux électrodes principales respectivement 3 et 8 et une grille de commande 2. Une première électrode principale peut être reliée à la masse tandis que l'autre est reliée à une ligne 5 dite ligne de bit. La grille de commande 2 est reliée à une autre connexion 9 dite ligne de mot. Les lignes de bit et lignes de mot sont arrangées en lignes et en colonnes pour déterminer une matrice incluant les points mémoire. Cette mémoire comporte des moyens, essentiellement un décodeur ligne 10 et un décodeur colonne 11, pour appliquer sur les lignes et les colonnes des potentiels représentatifs d'informations à enregistrer dans les points ou représentatifs de commande de lecture des informations enregistrées dans les points. Par exemple pour la lecture du point mémoire 7 on fait passer dans la ligne de bit 5 un courant produit par une sortie correspondante 12 du décodeur 10. Au moyen du décodeur colonne 11 on envoie sur la ligne de mot 9 une impulsion de commande. Le transistor 1 devient passant ou reste bloqué selon que des charges n'ont pas ou ont été au préalable piègées sur sa grille flottante 4. Un senseur de courant 13 connecté par ailleurs à une extrémité de la ligne de bit 5 détecte la variation, ou l'absence de variation, de courant. Il en déduit que le point mémoire était programmé à un, ou à zéro respectivement.

Une caractéristique importante de l'invention vient du fait que le potentiel appliqué sur la grille 2 n'est pas fabriqué par le décodeur 11, mais est fabriqué intrinsèquement par la mémoire elle-même. A cette fin celle-ci peut posséder un circuit oscillant dont une sortie est reliée à un redresseur. Mais d'une manière préférée elle comportera un générateur multiplicateur haute tension intégré 14 de type Schenkel. Ces générateurs Schenkel sont proches dans leur fonctionnement des multiplicateurs de tension idéaux. Ils comportent des arrangements en cellules de diodes et de capacités dont les bornes sont commutées par des impulsions d'horloge $V_H$ et $\overline{V_H}$. Ils sont alimentés par l'alimentation générale $V_{cc}$ de la mémoire. Le potentiel continu ainsi fabriqué peut être appliqué, selon les ordres de sélection élaboré par le décodeur 11, sur la grille de commande 2. Pour éviter toutes fluctuations accidentelles ou mal intentionnées du potentiel disponible à la sortie 17 du générateur 14, ce potentiel peut être calibré dans un calibrateur 18. De cette manière la sortie 19 du calibrateur 18 peut produire des tensions constantes et calibrées quelles que soient les conditions d'alimentation à $V_{CC}$, du générateur 14. Toutes tentatives de fraude consistant par ailleurs à agir sur l'alimentation générale de la mémoire sont ainsi également contrées. Il est possible de produire de cette manière tous les potentiels utiles : le potentiel $V_{PP}$ utile à la programmation, surtout le potentiel $V_{T1}$ utile à la vérification de la programmation, ou même le potentiel $V_T$ utile à la lecture des informations enregistrées dans les points. Dans une réalisation préférée le potentiel de programmation est fourni extérieurement. Ce n'est pas gênant puisque toutes tentatives de fraude sur ce potentiel peuvent être aisément repérées en utilisant un potentiel de vérification intouchable. Sur le plan pratique la production du potentiel $V_{PP}$ pourrait être obtenu en reliant un autre calibrateur en parallèle avec le calibrateur 18 : son entrée serait reliée à la connexion 17 sa sortie délivrerait le potentiel $V_{PP}$.

Dans le calibrateur 18 on limite la tension produite. Dans une réalisation préférée, ce calibrateur comporte un certain nombre de transistors, dans l'exemple trois, de même technologie (FAMOS) que le transistor utilisé en stockage d'information dans chaque point mémoire. Ici ce sont les transistors 41 à 43. Ces transistors 41 à 43 présentent seulement la particularité que leur grille flottante est court-circuitée à leur grille de commande. Les grilles de commande de chacun de ces transistors sont reliées à leur drain. Chacun constitue donc une diode et occasionne une chute de potentiel $V_{TO}$ calibrée.

Cette cascade de transistors 41 à 43 est alimentée par un transistor 44 déplété, polarisé à la limite du blocage avec sa grille reliée à l'électrode de source. Un transistor supplémentaire 45, en même technologie que les transistors 1 et dont la grille flottante est également court-circuitée à la grille de commande, reçoit sur sa grille le point milieu 46 du montage comportant le transistor 44 et la cascade des transistors 41 à 43. Le potentiel imposé à la grille du transistor 45 est donc calibré. Sur une première électrode principale ce transistor 45 reçoit le signal redressé en provenance du générateur 14. Il délivre donc sur sa deuxième électrode principale un signal de tension calibré $V_{T1}$. En effet, la tension à sa sortie est égale à la tension appliquée à sa grille diminuée de la chute de potentiel caractéristique entre source et grille. Le transistor 44 étant déplété, son seuil de conduction est nul. Un transistor non déplété dont la grille serait porté au potentiel de source resterait bloqué. Les transistors déplétés dans la figure 2 comportent une marque en forme de croix dans leur dessin.

On a vu plus haut que les points mémoires pouvaient être soumis à trois types de situation : l'écriture, la lecture, et la vérification. Dans l'invention et bien que cela ne constitue pas une obligation on a convenu de différencier ces situations par deux ordres différents : un premier ordre Ver (comme vérification) et un deuxième ordre RW (comme read-write pour lecture-écriture). Dans la convention choisie, pour une opération d'écriture en mémoire Ver vaudra un et RW vaudra zéro ; pour la lecture Ver vaudra un et RW aussi ; et pour la vérification Ver vaudra zéro et RW vaudra un. L'ordre Ver ainsi que les tensions $V_{pp}$ ou $V_T$ et $V_{T1}$ sont introduits dans un commutateur 47. Ce commutateur comporte deux transistors déplétés 48 et 49 en cascade. Une première électrode principale du transistor 48 est reliée à la source de tension $V_{T1}$ (sortie 19 du calibrateur 18) , sa deuxième électrode principale est reliée en un point milieu 50 à la première électrode principale du transistor 49. La deuxième électrode principale de 49 est reliée à la source de tension $V_{pp}$. La grille du transistor 49 reçoit l'ordre Ver. La grille du transistor 48 reçoit cet ordre Ver après qu'il soit passé dans un inverseur 51. Une connexion 71 raccordée au point milieu 50 est reliée par des transistors déplétés tels que 52 à chacune des lignes de mots 9. Le transistor déplété 52 dont la grille est reliée à une de ses bornes principales est équivalent à une résistance.

Les adresses des points mémoire à sélectionner transitent par un bus d'adresse 53 et sont traduites respectivement par les décodeurs 10 et 11. Pour la ligne choisie le décodeur 10 produit une tension d'alimentation. Pour la colonne repérée, une sortie choisie 58 du décodeur 11 produit un état zéro. Les sorties non choisies sont portées à un état électrique un à la sortie du décodeur 11. En face de chaque sortie du décodeur 11 se trouve un montage en cascade de deux transistors 54 et 55 entre la tension d'alimentation $V_{cc}$ et la masse. Le transistor 54 est un transistor déplété. La sortie 58 du décodeur commande la grille du transistor 55. Le point milieu 59 des deux transistors est relié à la grille du transistor 54 ainsi qu'à une électrode principale d'un transistor déplété 56. L'autre électrode principale du transistor déplété 56 est raccordé à la ligne de mot 9. La grille de commande du transistor 56 reçoit l'ordre de lecture-écriture RW par une connexion 57.

Pour chacune des trois situations on va étudier maintenant ce qu'il advient du point mémoire selon que l'adresse du point mémoire choisi est la bonne ou non. Dans une première opération on veut écrire le point mémoire 7 (Ver vaut un et RW vaut zéro). La sortie 58 considérée du décodeur 11 est alors portée à zéro. Le transistor 55 se bloque et il en résulte que le point milieu 59 des transistors 54, 55 se trouve porté à $V_{cc}$. Comme RW vaut zéro le transistor 56 se bloque. Ce transistor 56 se bloque parce que, comme on le verra plus loin, la tension appliquée sur son autre borne est supérieure à sa tension de seuil de blocage. En conséquence la tension sur la ligne de mot 9 va être imposée par la tension disponible sur la connexion 71. En effet le transistor 52, qui se comporte comme une résistance, ne provoque ici pas de chute de tension puisque le courant qui le traverse ne peut plus aller que dans la grille 2 du transistor 1 : c'est à dire qu'il est très faible. L'ordre Ver à un court-circuite le transistor 49 et ouvre le transistor 48. En conséquence la tension $V_{pp}$ vient s'appliquer au point milieu 50 relié à la connexion 71. Il en résulte que la tension $V_{pp}$ est portée sur la grille 2 du transistor, c'est justement ce que l'on cherche. A cet instant on envoie une impulsion de courant adéquate à la sortie 12 du décodeur 10, et le transistor 1 ainsi sélectionné se programme (à zéro ou à un selon l'impulsion disponible en 12).

Pour les transistors 1 qui n'ont pas été sélectionnés : c'est à dire ceux pour lesquels la connexion de sortie du décodeur 11 délivre un état un leur transistor 55 est court-circuité, leur point milieu 59 entre transistor 54 et 55 est donc porté à zéro. Comme l'ordre RW disponible sur la connexion 57 vaut zéro, mais comme les transistors 56 sont déplétés, ils sont quand même passants. Il en résulte que la tension $V_{pp}$ disponible sur la connexion 71 débite dans les résistances constituées par les transistors déplétés 52. Ceux-ci sont maintenant reliés à la masse par leur deuxième électrode principale : les autres lignes de mot ne sont donc pas portées au potentiel de programmation $V_{pp}$.

Pour l'opération de lecture on convient que les ordres Ver et RW valent un. Comme c'est une opération de lecture simple, on convient que les terminaux qui devront lire les contenus de ces mémoires mortes comporteront un raccordement tel qu'ils appliqueront une tension de lecture ($V_T$) en lieu et place de l'application précédente de la tension de programmation $V_{PP}$. Comme l'ordre Ver est identique au cas précédent c'est donc cette nouvelle tension de lecture ($V_T$) qui est appliquée sur la connexion 71. Pour la sortie 58 correspondant au point mémoire 7 choisi, l'état électrique vaut zéro. Le potentiel $V_{cc}$ est donc porté au point milieu 59. Le transistor déplété 56 reçoit alors sur sa grille un ordre RW à l'état un (soit $V_{cc}$), sur une première électrode principale la tension $V_{cc}$ en provenance du point milieu 59, et sur l'autre électrode principale une tension $V_T$ en provenance de la connexion 71 par le transistor déplété 52. Si $V_T$ est différent de $V_{cc}$ on calcule la surface du transistor 56 pour qu'il présente une résistance telle que la tension $V_T$ soit appliquée sur la grille 2 du transistor 1. Le rôle des transistors 56 est d'éviter l'établissement d'un chemin entre un potentiel d'écriture, de lecture ou de vérification très élevé et l'alimentation normale de la mémoire $V_{cc}$ (souvent de l'ordre de 5 volts). C'est pour cette raison qu'ici ils sont à la limite de la conduction.

Cette tension de lecture permet de lire l'état des charges piégés dans la grille flottante 4. Un générateur de courant débite alors dans la ligne de bit 5. Le senseur 13 détecte, ou ne détecte pas, une chute de courant liée à la mise en conduction du transistor 1. L'information qu'il relève est alors envoyée sur un bus de donnée 60. Pour les lignes de mot non sélectionnées par le décodeur 11, les points milieu 59 des transistors 54 et 55 sont portés au potentiel de la masse. Les transistors 56 conduisent : il reçoivent RW à un sur leur grille. Les lignes de mot non sélectionnées sont portées à la masse : les transistors des points mémoires qui leur sont affectés ne sont pas excités.

L'opération de vérification necéssite un ordre Ver à un état zéro et un ordre RW à un état un. Une porte ET 61 qui reçoit ces deux ordres délivre alors un état zéro sur la connexion 57. Le changement de valeur de l'ordre Ver par rapport au cas précédent fait basculer le commutateur 47. La tension $V_{T1}$ est maintenant disponible au moint milieu 50 relié à la connexion 51. Tout se passe comme pour l'écriture, sauf que $V_{T1}$ remplace $V_{pp}$. Si le point mémoire 7 était programmé sans charge piégée, le courant dans le senseur 13 doit varier : c'est normal. Par contre si le transistor 1 a été programmé avec des charges piégées, même en y appliquant $V_{T1}$, le courant dans le senseur 13 ne doit pas varier. Si le courant dans le senseur 13 varie, c'est qu'un nombre insuffisant de charges avaient été piégées. On peut exploiter cette information de lecture contraire à l'information attendue, pour empêcher toute utilisation ultérieure de la mémoire.

## Revendications

1. Mémoire morte (6) programmable électriquement du type à point mémoire (7) avec transistor (1) à grille flottante (4), et accessible matriciellement par des lignes (5) et des colonnes (9), comportant des moyens (10, 11) pour appliquer sur ces lignes et ces colonnes des potentiels représentatifs d'information à enregistrer dans les points ou représentatifs de commande de lecture (13) des informations enregistrées, caractérisée en ce qu'elle comporte des moyens intégrés comportant un multiplicateur haute tension (14) pour appliquer sur ces lignes et ces colonnes des potentiels dont les niveaux ($V_{T1}$) sont fixés intrinsèquement par la mise en cascade dudit multiplicateur haute tension (14) avec un calibrateur (18) appartenant à la mémoire.

2. Mémoire selon la revendication 1 caractérisée en ce que les moyens (10,11) pour appliquer des potentiels comportent des lignes(5), dites lignes de bit, reliées premièrement aux sorties (12) d'un décodeur ligne (10), deuxièmement à des senseurs (13) d'information, et troisièmement à des connexions principales (8) de transistors à grille flottante, et des colonnes (9), dites lignes de mot, reliées premièrement aux sorties (58) d'un décodeur colonne (11), deuxièmement aux grilles de commande (2) des transistors à grille flottante, et troisièmement à des circuits (52) résistifs d'application des potentiels de lecture et d'écriture.

3. Mémoire selon l'une quelconque des revendications 1 à 2 caractérisée en ce que le multiplicateur (14) est de type Schenkel.

4. Mémoire selon l'une quelconque des revendications 1-3 caractérisé en ce que le calibrateur (18) comporte un arrangement (41 - 43) en cascade de transistors en technologie (FAMOS) identique à celle du transistor du point mémoire, ces transistors étant traversés par un courant de saturation et alimentés par un transistor déplété (44).

5. Mémoire selon la revendication 4 caractérisé en ce que le calibrateur en (18) comporte un transistor (45) de même technologie que celui du point mémoire, reçevant sur une première électrode principale (17) le potentiel produit par le multiplicateur (14), sur sa grille de commande une tension calibrée produite au point milieu (46) du montage comprenant ledit transistor déplété (44) et ladite cascade de transistor (41-43), et débitant par sa deuxième électrode principale (19) le potentiel calibré recherché (VT1).

6. Mémoire selon l'une quelconque des revendications 1 à 5 caractérisée en ce qu'elle comporte des moyens (47) pour commuter les potentiels à appliquer (VT1,VT,VPP).

7. Mémoire selon l'une quelconque des revendications 1 à 6 caractérisée en ce qu'elle comporte des moyens de sélection (61, 47) pour permettre l'application de potentiels différents (VT1,VT,VPP).

8. Mémoire selon la revendication 2 caractérisé en ce que les lignes de mot (9) sont reliées aux sorties du décodeur colonne (11) par l'intermédiaire d'un circuit de validation (54-59) recevant d'une part les adresses colonne des points mémoires et d'autre part un ordre de validation (RW,Ver) pour drainer les courants appliqués par un circuit résistif (52).

**Patentansprüche**

1. Elektrisch programmierbarer Festwertspeicher (6) von einem Typ, dessen Speicherpunkte (7) einen Transistor (I) mit schwebendem Gate (4) aufweisen und auf den über Zeilen (5) und Spalten (9) matrixförmig zugegriffen werden kann, mit Mitteln (10, 11) zum Anlegen von Potentialen an diese Zeilen und diese Spalten, die die in die Punkte einzutragende Information darstellen oder den Lesebefehl (13) für die eingetragenen Informationen darstellen, dadurch gekennzeichnet, daß er integrierte Mittel aufweist, die einen Hochspannungs- Multiplikator (14) enthalten, um an diese Zeilen und diese Spalten Potentiale anzulegen, deren Pegel (VT1) intrinsisch durch die Kaskadenschaltung des Hochspannungs-Multiplikators (14) mit einem dem Speicher zugehörigen Kalibrator (18) festgelegt werden.

2. Speicher gemäß Anspruch 1, dadurch gekennzeichnet, daß die Mittel (10, 11) zum Anlegen von Potentialen Zeilen (5), die Bitzeilen genannt werden und erstens mit den Ausgängen (12) eines Zeilendekoders (10), zweitens mit Informationssensoren (13) und drittens mit den Hauptverbindungen (8) der Transistoren mit schwebendem Gate verbunden sind, und Spalten (9), die Wortzeilen genannt werden und erstens mit den Ausgängen (58) eines Spaltendekoders (11), zweitens mit den Steuergates (2) der Transistoren mit schwebendem Gate und drittens mit resistiven Schaltungen (52) zum Anlegen von Lese- und Schreibpotentialen verbunden sind, aufweisen.

3. Speicher gemäß einem der Ansprüche 1 bis 2, dadurch gekennzeichnet, daß der Multiplikator (14) vom Schenkel-Typ ist.

4. Speicher gemäß einem der Ansprüche 1 bis 3, dadurch gekennzeichnet, daß der Kalibrator (18) eine Kaskadenanordnung (41-43) von Transistoren einer Technologie (FAMOS), die mit derjenigen des Speicherpunkt-Transistors identisch ist, aufweist, wobei diese Transistoren von einem Sättigungsstrom durchflossen und von einem Verarmungstransistor (44) versorgt werden.

5. Speicher gemäß Anspruch 4, dadurch gekennzeichnet, daß der Kalibrator (18) einen Transistor (45) der gleichen Technologie wie diejenige des Speicherpunktes aufweist, wobei der Transistor (45) an einer ersten Hauptelektrode (17) das vom Multiplikator (14) erzeugte Potential und an seinem Steuergate eine kalibrierte Spannung, die am Mittelpunkt (46) des den Verarmungstransistor (44) und die Transistorkaskade (41-43) umfassenden Aufbaus erzeugt wird, empfängt und über seine zweite Hauptelektrode (19) das gesuchte kalibrierte Potential (VT1) ausgibt.

6. Speicher gemäß einem der Ansprüche 1 bis 5, dadurch gekennzeichnet, daß er Mittel (47) zum Umschalten der anzulegenden Potentiale (VT1, VT, VPP) aufweist.

7. Speicher gemäß einem der Ansprüche 1 bis 6, dadurch gekennzeichnet, daß er Auswahlmittel (61, 47) aufweist, die das Anlegen unterschiedlicher Potentiale (VT1, VT, VPP) gestatten.

8. Speicher gemäß Anspruch 2, dadurch gekennzeichnet, daß die Wortzeilen (9) mit den Ausgängen des Spaltendekoders (11) über eine dazwischengeschaltete Validierungsschaltung (54-59) verbunden
sind, die einerseits die Spaltenadressen der Speicherpunkte und andererseits einen Validierungsbefehl (RW, Ver) empfängt, um die von einer resistiven
Schaltung (52) eingegebenen Ströme abzuzsaugen.

## Claims

1. An electrically programmable rom (6) of the
type with a memory point (7) with a transistor (1) having a floating gate (4) and being accessible matrix-
wise through lines (5) and columns (9), comprising
means (10 and 11) for the application by way of these
lines and these columns of potentials representative
of information to be stored in the points or representative of a read control (13) for the stored information,
characterized in that it comprises integrated means
comprising a high voltage multiplier (14) for the application to such lines and to such columns of potentials
whose levels ($V_{T1}$) are intrinsically set by putting into
series of the said multiplier at a high voltage (14) with
a calibrator (18) belonging to the memory.

2. The memory as claimed in claim 1, characterized in that the means (10 and 11) for the application of the potentials comprises lines (5), termed bit
lines, connected firstly to the outputs (12) of a line
decoder (10), secondly to information sensors (13)
and thirdly to the main connections (8) of floating gate
transistors, and columns (9), termed the word lines,
connected firstly to the outputs (58) of a column
decoder (11), secondly to the control gates (2) of the
floating gate transistors, and thirdly to resistance circuits (52) for the application of read an d write potentials.

3. The memory as claimed in claim 1 or claim 2,
characterized in that the multiplier (14) is of the
Schenkel type.

4. The memory as claimed in any one of the preceding claims 1 through 3, characterized in that the
calibrator (18) comprises an arrangement (41 through
43) of series transistors in a technology (FAMOS)
identical to that of the transistor of the memory point,
said transistors having a saturation current passing
through them and being supplied by a depleted transistor (44).

5. The memory as claimed in claim 4, characterized in that calibrator (18) comprises a transistor
(45) in the same technology as that of the memory
point, receiving at a first principal electrode (L7) the
potential produced by the multiplier (14), at its control
gate a calibrated voltage produced at the center point
(46) of assembly comprising the said depleted transistor (44) and the said series of transistor (41 through
43) and supplying at its second principal electrode
(19) the desired calibrated potential (VT1).

6. The memory as claimed in any one of the preceding claims 1 through 5, characterized in that it
comprises means (47) in order to switch the potentials
to be applied (VT1, VT and VPP).

7. The memory as claimed in any one of the preceding claims 1 through 6, characterized in that it
comprises means for selection (61 and 47) in order to
permit the application of different potentials (VT1, VT
and VPP).

8. The memory as claimed in claim 2, characterized in that the word lines (9) are connected to the
outputs of the column decoder (11) by means of an
enabling circuit (54 through 59) receiving on the one
hand the column addresses of the memory points and
on the other hand an enabling order (RW, Ver) in
order to drain the currents applied by a resistance circuit (52).

Fig.1a

Fig.1b

EP 0 217 846 B1

Fig.2

9